# EUROPEAN PATENT SPECIFICATION

(11) **EP 0 360 550 B1**
(45) Date of publication and mention of the grant of the patent: **20.07.1994**
(21) Application number: 89309490.4
(22) Date of filing: 19.09.1989
(51) Int. Cl.: C04B 35/00, D01F 9/08, B32B 18/00, H01L 39/24, H01L 39/12

(54) **Fibres of YBa2 Cu3 O7**
Fasern aus YBa2 Cu3 O7
Fibres de YBa2 Cu3 O7

(30) Priority: 20.09.1988 US 246977
(43) Date of publication of application: 28.03.1990
(73) Proprietor: MINNESOTA MINING AND MANUFACTURING COMPANY, St. Paul, Minnesota 55133-3427 (US)
(72) Inventor: Budd, Kenton D. c/o Minnesota Mining and, P.O. Box 33427 St. Paul Minn. 55133-3427 (US)
(74) Representative: Baillie, Iain Cameron

(56) References cited:
- JOURNAL OF APPLIED PHYSICS, vol. 63, no. 8, 15th April 1988, pages 2725-2729,American Institute of Physics; P. BARBOUX et al.: "Bulk and thick films ofthesuperconducting phase YBa2Cu3O7-y made by controlled precipitation sol-gelprocesses"
- APPLIED PHYSICS LETTERS, vol. 51, no. 3, 20th July 1987, pages 203-204, American Institute of Physics; S. JIN et al.: "High Tc superconductors-composite wire fabrication"
- ADVANCED CERAMIC MATERIALS, vol. 2, no. 3B, 1987, pages 364-371; D.W. JOHNSON,Jr. et al.: "Fabrication of ceramic articles form high Tc superconducting oxides"
- MATERIALS SCIENCE & ENGINEERING B, vol. B1,no.1, August 1988, pages 29-36, Elsevier Sequoia, Lausanne, CH; J.M. TARASCON et al.: "On synthesis of high Tc superconducting perovskites"

## Description

The invention concerns superconductive ceramic and particularly concerns fibres of superconductive ceramic having the formula YBa₂Cu₃O₇ that can be produced by a sol-gel process.

Beginning in 1986, there were reports of a new class of ceramic oxide materials which exhibit superconductivity at unprecedentedly high temperatures. Among these is orthorhombic YBa₂Cu₃Oₓ (where x is typically between 6.5 and 7.2) which is often called "YBa₂Cu₃O₇" or "123 superconductive ceramic" by virtue of its metallic molar ratios. It is the first material known to exhibit superconductivity above the boiling point of liquid nitrogen (77°K or -196°C). The historical development of these ceramic oxide materials is described in Clarke, "The Development of High-Tc Ceramic Superconductors: An Introduction," Advanced Ceramic Materials, Vol. 2, No. 3B, pp 273-292, (1987).

Other articles in that same special issue of Advanced Ceramic Materials describe preliminary studies of the crystallography, physical properties, processing, and theory of these new ceramic oxide materials. Most of these studies report fabrication of bulk ceramic samples by conventional ceramic processing methods. For example, Johnson et al. (pp 364-371) describe mixing, milling, calcining (900°C), and regrinding of oxide and carbonate powders to yield YBa₂Cu₃O₇ powder that was formed into bulk ceramic samples which were then sintered at 950-990°C for 3-8 hours. A few of the studies report liquid chemical methods for preparing these new ceramic oxide materials.

For example, Dunn et al. (pp 343-352) synthesize YBa₂Cu₃O₇ powder by the amorphous citrate process, a well known technique for synthesizing perovskite compounds. After dissolving nitrate salts of Y, Ba and Cu, citric acid was added and water was evaporated from the solution until it became a viscous liquid which was further dehydrated to form an amorphous solid precursor that was then fired to form the desired compound. The large volume of fugitive combustion products formed during pyrolysis would convert the dried precursor into a powder during the firing.

Johnson et al. (pp 337-342) form YBa₂Cu₃O₇ powder by freeze-drying aqueous solutions of Y, Ba and Cu nitrates.

Cima et al. (pp 329-336) are primarily concerned with improving the microstructure of YBa₂Cu₃O₇ and report high density samples made from powders produced by solid state reaction. However, at page 332, they state that they "have synthesized Y_{1.2}Ba_{0.8}Cu(OH)ₓ by preparing an emulsion of an aqueous solution of Y, Ba, and Cu salts in heptane and coprecipitating the hydroxides in the emulsion droplets (microreactors) by bubbling ammonia through the emulsion."

Dagani, C&E News, May 11, 1987, pages 7-16, also reports studies of YBa₂Cu₃O₇ and says (pp 13-14):
"Because these ceramics tend to be brittle and fragile, they cannot be drawn out to form wires as copper and other ductile metals can.... (W)ires are made by filling hollow metal wire (such as silver) with Y-Ba-Cu-0 powder and drawing out the wire to the desired diameter.... At 77 K, they measure a current density of about 175 amp per sq cm. Jin (of Bell Labs) admits this is 'rather low,' but he says it is consistent with typical bulk superconductors.
"Another approach is to mix the ceramic powder or its ingredients with an organic binder and then extrude a thin 'noodle' of the plastic material through a die. At that stage, the extruded wire can easily be bent or deformed. But it must be fired to burn off the binder and sinter the powders into a current-carrying filament."
Clarke (pp 280) says concerning YBa₂Cu₃O₇: "The first films to exhibit complete superconductivity above liquid nitrogen were prepared by electron beam evaporation through a partial pressure of oxygen onto sapphire and MgO substrates maintained at typically 450°C.... More recently a number of groups have been successful in producing thin films by d.c. magnetron sputtering ... and also by ion beam sputtering."
At the same page, Clarke discusses fibers, including attempts to pull fibers from a gel and then fire them to convert the gel to superconducting form.

Clarke says (p 277) "that any rare earth element (other than La) could be used to substitute, wholly or in part, for the yttrium without markedly altering the superconducting transition temperature". Dagani says (p 12) researchers have found that "when yttrium is replaced by samarium, europium, gadolinium, dysprosium, holmium, or ytterbium, the ceramic still becomes superconducting around 90 K."

The formation of ceramic powders, fibers and films by the sol-gel process is well known. See, for example, Uhlmann et al., Mat. Res. Soc. Symp. Proc., Vol. 32, pp 59-62 (1984) and U.S. Pat. No. 4,166,147 (Lange et al.). The latter teaches, among other things, the shaping, gelling, and firing of metal oxide sol or solution precursors to provide shaped articles such as fibers useful in fabricating woven, felted, knitted, and other types of textiles. It also is known that as compared to ceramic thin films made by vacuum techniques, ceramic thin films can be formed more economically by the sol-gel process.

J. Appln. Phys. 63, No. 8 (1988) pp 2725-2729 P, Barboux et al and also Materials Science & Engineering B, B1 No. 1 (1988) pp 29-36 J.M. Tarascon et al disclose a sol-gel process for the production of thick films of YBa₂Cu₃O₇.

Appl. Phys. Lett. 51, No.3 (1987) pp 203-204 S.Jin et al discloses a method of forming metal coated superconducting wire involving drawing a composite comprising a metal tube containing heat-treated YBa₂Cu₃O₇ powder. The wires have a diameter of from 1.52 mm (0.060 inches) to 0.254 mm (0.010 inches).

The invention provides a method of making a superconductive fibre, said method comprising the steps of
a) mixing an aqueous solution of barium hydroxide with a compatible aqueous solution of copper carboxylate and at least one of a compatible aqueous solution of yttrium carboxylate and an aqueous suspension of colloidal oxide of yttrium to provide a sol having a Y:Ba:Cu molar ratio of approximately 1:2:3,
b) adjusting the concentration of the sol to permit it to be formed into a fibre,
c) forming and drying the sol to form a fibre, and
d) firing to convert the fibre into orthorhombic superconducting YBa₂Cu₃O₇, the fired fibre having a diameter of less than about 50 »m.

By "compatible" is meant that the sol does not precipitate an insoluble compound before the shaped article can be formed in step c). The sol usually is a clear blue liquid that exhibits continuously increasing, but stable, viscosities when concentrated; is metastable when supersaturated; and is clear, glassy, and homogeneous when dried. When the sol is somewhat translucent, it may become almost transparent upon being concentrated to a fiberizable viscosity.

Included within "oxide of yttrium" are hydrous oxides.

Y and Cu carboxylates that are most useful in the above-outlined method have from 2 to 3 carbon atoms and, when admixed with aqueous barium hydroxide, are suitably chelating to resist the formation of insoluble hydrolysis products (e.g., oxides or hydroxides) and yet yield products having sufficient molecular complexity to provide a viscous, metastable precursor when concentrated. Carboxylates having 2-3 carbon atoms also afford green strength to the shaped articles while keeping the content of fugitive material to a minimum.

The invention enables the production of continuous superconducting fibers of sufficiently fine diameter to be usefully flexible. To be usefully flexible, a fiber may need to be less than 50 »m in diameter. Its preferred diameter may be from 0.5 to 10 »m, because it may be difficult to avoid undue porosity and distortion due to outgassing if the diameter were significantly larger.

Accordingly the invention provides a fine diameter fiber comprising orthorhombic superconducting YBa₂Cu₃Oₓ, wherein x is in the range of from 6.5 to 7.2 and further wherein said fiber has a diameter less than or equal to about 50 »m.

When making a superconducting fiber of the invention from the sol produced in step a) of the above-outlined method, the sol should be of a fiberizable viscosity, and this may require the concentration of the sol to be increased in step b) by evaporating water.

As is known in the art, superconducting YBa₂Cu₃O₇ fibers would degrade chemically upon exposure to atmospheric moisture and preferably are protected by a coating of ductile metal that also would enhance their mechanical properties. The ductile metal preferably is electrically conductive, e.g., a silver coating applied by electroplating, especially when the YBa₂Cu₃O₇ fibers are discontinous. A useful composite wire-like electrical conductor comprises a plurality of orthorhombic superconducting YBa₂Cu₃O₇ fibers encased in a matrix of elecrically conductive metal.

Before converting the sol into a fibre it usually is possible to suspend in the sol finely divided YBa₂Cu₃O₇ powder in amounts such that it provides up to about one-half of the total weight of the superconductor.

In step a) of the above-outlined method, preferably 0.1 to 0.5 molal aqueous solutions of the Cu and Y containing constituents are combined, followed by addition of 0.1 to 0.5 molal barium hydroxide solution while rapidly stirring the mixture. The resultant dilute mixtures are stable to the precipitation of insoluble hydrolysis products for a period of days to weeks. Furthermore, the mixtures are metastable when concentrated and resist the precipitation of crystalline salts from the supersaturated mixtures for several hours to several days.

When making fibres of orthorhombic superconducting YBa₂Cu₃O₇ by the above-outlined method of the invention, compositional variations may be introduced, e.g., to increase the resistance of the sol to precipitation of hydrolysis products upon the addition of barium hydroxide, or to help prevent precipitation of crystalline salts upon concentrating the sol, or to modify the pyrolysis behavior. For example, various combinations of carboxylate salts of Y and Cu can be employed, including combinations with mineral salts. Other useful compositional variations involve the addition of small amounts of carboxylic or mineral acids to the sol and/or the use of off-stoichiometric Y-Ba-Cu-O formulations while maintaining a sol that predominantly yields the YBa₂Cu₃O₇ phase.

To illustrate a useful compositional variation, resistance to the precipitation of hydrolysis products can be enhanced by adding to the sol small quantities of carboxylic acid such as acetic acid and lactic acid, preferably after completing step a) of the above-outlined process, but not more than about 1 equivalent of acid per mole of Ba. Larger quantities would tend toward complete neutralization of the hydroxide, yielding essentially stoichiometric salt solutions which cannot be concentrated to a suitably high viscosity and thus would form inhomogeneous mixtures of crystalline salts upon drying.

### Example 1

Aqueous stock solutions were made by dissolving in water commercially available compounds to provide
0.1 mole yttrium acetate/kg of solution,
0.2 mole barium hydroxide/kg of solution, and
0.3 mole copper acetate/kg of solution.
200 g of each solution were combined into a sol that was concentrated at 35°C using a rotary evaporator until sufficiently viscous for fiber formation (estimated to be about 50,000 - 100,000 cp).

Fibers were spun by extruding through 75-»m holes at 200 psi (1380 kPa), drying, stretching through a 6-foot (2-m) tower at 80-90°F (27-32°C), 30% R.H., and winding at about 40 feet/min. (13 m/min.). The fibers were clear blue, transparent, 10-30 »m in diameter, and were cut to lengths of about 10 to 15 cm to fit into a ceramic boat.

After being stored in a dryer at 95°C for about one month, the fibers were converted to YBa₂Cu₃O₇ by firing from room temperature to 950°C using a 150°C/hour heating rate and then holding at 950°C for 30 minutes. The fired fibers were porous and fragile and somewhat deformed. X ray diffraction showed that the fired fibers were monophasic and orthorhombic, and scanning electron microscopy showed them to have a grain size of about 1 to 5 »m.

### Example 2

Dissolved in water were:
0.05 mole suspension of colloidal Y₂0₃/kg (from "Nyacol"),
0.2 mole barium hydroxide/kg, and
0.3 mole copper lactate/kg.
500 g of each were combined to produce a sol that was concentrated at 35°C using a rotary evaporator until its viscosity was about the same as was attained in Example 1.

Fibers were spun by extruding through 75-»m holes at 300 psi (2070 kPa), drying, stretching through a 6-foot (2-m) tower at about 90°F (32°C), 40% R.H., and winding at about 30 feet/min. (9 m/min.). The fibers were clear blue, transparent, and 15-35 »m in diameter.

After being stored in a dryer at 95°C for about one month, the fibers were converted to orthorhombic YBa₂Cu₃O₇ by firing at linearly increasing temperatures as follows:
RT to 250°C over 2 hours
250° to 300°C over 2 hours
300° to 400°C over 1 hour plus 3 hours at 400°C
400° to 600°C over 3 hours
600° to 900°C over 1 hour plus 1 hour at 900°C
The fired fibers were less deformed than were those of Example 1 and also were porous and fragile. Their grain size was about 0.5 to 3 »m.

### Example 3

The concentrated sol of Example 2 was diluted with water, then reconcentrated by the procedure of Example 2 until the viscosity was about one-half that attained in Examples 1 and 2. This was extruded into a jet of air to produce fibers that were collected on a screen. The fibers were clear blue, transparent, and 0.5 to 10 »m in diameter.

The fibers were converted to orthorhombic YBa₂Cu₃O₇ by firing at linearly increasing temperatures as follows:
25° to 260°C over 1.5 hours
260° to 600°C over 12 hours
600° to 900°C over 2 hours plus 1/2 hour at 900°C
Of these fired fibers, those that were less than about 3 »m in diameter were completely dense and less fragile than were the fired fibers of Examples 1 and 2.

### Example 4

Three aqueous systems were used, namely,
0.620 mole suspension of colloidal Y₂0₃/kg (from "Nyacol"),
0.182 mole barium hydroxide/kg, and
0.470 mole copper lactate/kg.
36.3 g, 495 g, and 287 g of these three systems, respectively, were combined to provide a sol having a Y:Ba:Cu molar ratio of 1:2:3. This was concentrated to about 100 ml at 35°C using a rotary evaporator. To the concentrated sol (which contained enough precursor for 30g of YBa₂Cu₃O₇) was added 20 g of jet-milled YBa₂Cu₃O₇ powder (mean diameter about 2-3 »m). The resulting mixture was milled in a "Spex" shaker mill and then concentrated in the same way to a fiberizable viscosity.

Fibers were spun by extruding through 75-»m holes at about 90°F (32°C), 35% R.H., and 50 ft/min. (15.2 m/min.). The resulting black fibers were 10-60 »m in diameter and were fired at 1°C/min. from RT to 925°C and held at 925°C for one hour. This converted the fibers to orthorhombic YBa₂Cu₃O₇ having diameters ranging from 5 to 60 »m. A resistance of 335 ohms/cm at 25°C was measured for a fired fiber having a diameter of about 43 »m.

### Example 5

Three aqueous solutions were used:
0.1 mole yttrium acrylate/kg,
0.2 mole barium hydroxide/kg, and
0.3 mole copper acrylate/kg.
350 g of each of these three solutions, 1000 g of methoxyethanol, and 0.05 moles of acrylic acid were combined into a sol that was concentrated to fiberizable viscosity.

Fibers were spun in the same way as in Example 1, but with difficulty due to breakage and lower green strength.

## Claims

1. A method of making a superconductive fibre, said method comprising the steps of
a) mixing an aqueous solution of barium hydroxide with a compatible aqueous solution of copper carboxylate and at least one of a compatible aqueous solution of yttrium carboxylate and an aqueous suspension of colloidal oxide of yttrium to provide a sol having a Y:Ba:Cu molar ratio of approximately 1:2:3, compatible meaning that the sol does not precipitate an insoluble compound before the shaping step (c).
b) adjusting the concentration of the sol to permit it to be formed into a fibre,
c) forming and drying the sol to form a fibre, and
d) firing to convert the fibre into orthorhombic superconducting YBa₂Cu₃O₇, the fired fibre having a diameter of less than about 50 »m.

2. A method as claimed in claim 1 wherein each carboxylate has 2-3 carbon atoms.

3. A method as claimed in claim 1 wherein the copper carboxylate is copper acetate and the yttrium precursor of step a) is yttrium acetate.

4. A method as claimed in claim 1 wherein the copper carboxylate is copper lactate and the yttrium precursor is a suspension of colloidal oxide of yttrium.

5. A method as claimed in any preceding claim wherein the diameter of the fiber is from 0.5 to 10 »m.

6. A fine diameter fiber comprising orthorhombic superconducting YBa₂Cu₃Oₓ, wherein x is in the range of from 6.5 to 7.2 and further wherein said fiber has a diameter less than or equal to about 50 »m.

7. A fiber according to claim 6 wherein said fiber has a diameter in the range of about 0.5 »m to about 10 »m.

8. A fiber according to claim 6 wherein said fiber has a coating of a ductile metal thereon.

9. A fiber according to claim 8 wherein said ductile metal is electrically conductive.

10. A fiber according to any of claims 6 to 9 wherein said fiber has a grain size in the range of 0.5 »m to 5 »m.

11. A continuous fiber according to any of claims 6 to 10.

## Patentansprüche

1. Verfahren zum Herstellen einer supraleitfähigen Faser mit folgenden Schritten:
a) zum Herstellen eines Sols mit einem Y:Ba:Cu-Molverhältnis von etwa 1:2:3 wird eine wäßrige Lösung von Bariumhydroxid mit einer kompatiblen wäßrigen Lösung von Kupfercarboxylat und mindestens einer der folgenden Substanzen gemischt: eine kompatible wäßrige Lösung von Yttriumcarboxylat und eine wäßrige Suspension eines kolloidalen Oxids des Yttriums, wobei der Ausdruck kompatibel bedeutet, daß vor dem Formungsschritt c) keine unlösliche Verbindung aus dem Sol ausfällt,
b) das Sol wird auf eine solche Konzentration eingestellt, daß es zu einer Faser geformt werden kann,
c) zum Herstellen einer Faser wird das Sol geformt und getrocknet, und
d) die Fasern werden durch Brennen in orthorhombisches supraleitfähiges YBa₂Cu₃O₇ umgewandelt, wobei die gebrannte Faser einen Durchmesser unter etwa 50 Mikrometer hat.

2. Verfahren nach Anspruch 1, in dem jedes Carboxylat 2 bis 3 Kohlenstoffatome besitzt.

3. Verfahren nach Anspruch 1, in dem das Kupfercarboxylat Kupferacetat und die Yttriumvorstufe im Schritt a) Yttriumacetat ist.

4. Verfahren nach Anspruch 1, in dem das Kupfercarboxylat Kupferactat und die Yttriumvorstufe eine Suspension eines kolloidalen Oxids des Yttriums ist.

5. Verfahren nach einem der vorhergehenden Ansprüche, in dem der Durchmesser der 0,5 bis 10 Mikrometer beträgt.

6. Feindurchmesserfaser, die wenigstens teilweise aus orthorhombischem supraleitfähigem YBa₂Cu₃Oₓ besteht, wobei x im Bereich von 6,5 bis 7,2 liegt und die Faser einen Durchmesser von höchstens 50 Mikrometern hat.

7. Faser nach Anspruch 6, die einen Durchmesser im Bereich von etwa 0,5 bis 10 Mikrometern hat.

8. Faser nach Anspruch 6, auf der ein Überzug aus einem duktilen Metall vorgesehen ist.

9. Faser nach Anspruch 8, in der das duktile Metall elektrisch leitfähig ist.

10. Faser nach einem der Ansprüche 6 bis 9, die eine Korngröße im Bereich von 0,5 bis 5 Mikrometern hat.

11. Endlosfaser nach einem der Ansprüche 6 bis 10.

## Revendications

1. Procédé pour la fabrication d'une fibre superconductrice, ledit procédé comprenant les étapes consistant à :
(a) mélanger une solution aqueuse d' hydroxyde de baryum avec une solution aqueuse compatible de carboxylate de cuivre et au moins l'une des solution et suspension suivantes : solution aqueuse compatible de carboxylate d'yttrium, et suspension aqueuse colloïdale d'oxyde d'yttrium, pour fournir un sol ayant un rapport molaire Y/Ba/Cu d'environ 1/2/3, le terme compatible signifiant que le sol ne donne pas un précipité de composé insoluble avant l'étape (c) de mise en forme,
(b) ajuster la concentration du sol afin de permettre à celui-ci d'être transformé sous la forme d'une fibre,
(c) former et sécher le sol pour former une fibre, et
(d) cuire pour convertir la fibre en superconducteur orthorhombique YBa2Cu3O7, la fibre cuite ayant un diamètre inférieur, à environ 50 »m.

2. Procédé suivant la revendication 1, dans lequel chaque carboxylate comporte de 2 à 3 atomes de carbone.

3. Procédé suivant la revendication 1, dans lequel le carboxylate de cuivre est l'acétate de cuivre et le précurseur d'yttrium de l'étape (a) est l'acétate d'yttrium.

4. Procédé suivant la revendication 1, dans lequel le carboxylate de cuivre est le lactate de cuivre et le précurseur d'yttrium est une suspension colloïdale d'oxyde d'yttrium.

5. Procédé selon l'une quelconque des revendications précédentes, dans lequel le diamètre de la fibre est de 0,5 à 10 »m.

6. Fibre de fin diamètre comprenant le superconducteur orthorhombique YBa₂Cu₃Oₓ, où x est situé dans l'intervalle de 6,5 à 7,2, ladite fibre ayant en outre un diamètre inférieur ou égal à environ 50 »m.

7. Fibre suivant la revendication 6, dont le diamètre est compris entre environ 0,5 »m. et environ 10 »m.

8. Fibre suivant la revendication 6, comprenant sur sa surface un revêtement de métal ductile.

9. Fibre suivant la revendication 8, dans laquelle ledit métal ductile est électriquement conducteur.

10. Fibre suivant l'une quelconque des revendications 6 à 9, caractérisée en ce qu'elle a une épaisseur comprise entre 0,5 »m et 5 »m.

11. Fibre suivant l'une quelconque des revendications 6 à 10, caractérisée en ce qu'elle est continue.
